# EUROPEAN PATENT APPLICATION

(11) **EP 4 823 300 A1**
(43) Date of publication of application: **14.10.2026**
(21) Application number: 26166035.1
(22) Date of filing: 19.03.2026
(51) Int. Cl.: H10K 59/131, H10K 59/122, H10K 59/126

(54) **DISPLAY DEVICE WITH UNIFORM DRIVING VOLTAGE AND ELECTRONIC DEVICE INCLUDING THE SAME**

(30) Priority: 10.04.2025 KR 20250046469
(71) Applicant: Samsung Display Co., Ltd., Yongin-si, Gyeonggi-do 17113 (KR)
(72) Inventor: LEE, Sungeun, 17113 Yongin-si (KR); KANG, Ki Nyeng, 17113 Yongin-si (KR); KIM, Sikwang, 17113 Yongin-si (KR); PARK, Jonghee, 17113 Yongin-si (KR); SONG, Keunkyu, 17113 Yongin-si (KR); LEE, Jaehun, 17113 Yongin-si (KR)
(74) Representative: Walaski, Jan Filip

(57) **Abstract**

A display panel of an electronic device includes a substrate which includes a display region and a non-display region including a scan region, pixels, a pixel-defining layer which includes openings, a partition wall which is disposed on the pixel-defining layer and includes a first pattern overlapping the display region and a second pattern extending from the first pattern and overlapping the non-display region, a signal line receiving a voltage associated with an operation of the display panel, and a protective electrode which overlaps the scan region, and the protective electrode is connected to the signal line through the second pattern.

## Description

### CROSS-REFERENCE TO RELATED APPLICATION(S)

This application claims priority to Korean Patent Application No. 10-2025-0046469 filed on 10 April 2025, in the Korean Intellectual Property Office.

### 1. Technical Field

The disclosure is directed to a display device and an electronic device including the same, and more particularly, to a display device with a uniform driving voltage.

### 2. Discussion of Related Art

Electronic devices such as smartphones, digital cameras, laptops, navigation systems, and smart televisions use a display device to present images to a user. The display device generates the images from image data and provides the generated images to the user through a display panel of the display device.

The electronic device includes multiple pixels for generating images and multiple signal lines connected to those pixels. The pixels are driven by drivers that supply driving signals through the signal lines.

As display panels have become larger and more complex, variations in a driving voltage transferred to individual pixels have increased. Such voltage inconsistencies can cause non-uniform brightness, color shift, or image artifacts across the display panel. However, the drivers are increasingly exposed to external electrical noise or electrostatic discharge, which can lead to instability, malfunction, or long-term reliability issues in the display device.

### SUMMARY

At least one embodiment provides a display device capable of providing a uniform driving voltage to its pixels, and an electronic device including the same. The display device in further embodiments may also protect a driver circuit (e.g., a scan driver) from external electrical noise or electrostatic discharge.

According to an embodiment, an electronic device is provided. The electronic device includes a display panel. The display panel includes a display region and a non-display region adjacent to the display region. The non-display region includes a scan region having a scan driver. The display panel further includes: a substrate which includes light-emitting regions disposed in the display region and a peripheral region disposed between the light-emitting regions; a plurality of pixels overlapping the display region; a pixel-defining layer overlapping the peripheral region and including openings exposing at least portions of the light-emitting regions; a partition wall disposed on the pixel-defining layer, the partition wall including a first pattern overlapping the display region and a second pattern extending from the first pattern to overlap the non-display region; a signal line disposed between the display region and the scan region, where the signal line is configured to receive a driving voltage for driving the pixels; and a protective electrode overlapping the scan region and the scan driver, and the protective electrode is connected to the signal line through the second pattern.

In an embodiment, the protective electrode is disposed on the same layer as electrodes of the light emitting elements of the pixels and the signal line is disposed lower than the electrodes.

The first pattern may be disposed on the pixel-defining layer and have a lattice shape spaced apart from the openings, and the second pattern may include a normal pattern extending from the first pattern and having a shape similar to a shape of the first pattern and connection patterns extending from the normal pattern in a direction towards the signal line and spaced apart from each other.

The protective electrode may include first electrodes arranged along a first direction and extending along a second direction crossing the first direction, second electrodes arranged along the second direction and disposed between the first electrodes adjacent to each other along the first direction, and third electrodes arranged along the second direction and protruding, in a direction to the signal line, from the first electrode adjacent to the signal line.

The first electrodes adjacent to each other along the first direction and second electrodes disposed between the first electrodes of the protective electrode may define an electrode hole.

The electrode hole may be provided as a plurality of electrode holes arranged along the second direction to define hole groups, and electrode holes included in hole groups adjacent to each other along the first direction may be shifted along the second direction.

The connection patterns and the third electrodes may be alternately arranged on the signal line along the second direction.

The connection patterns and the third electrodes may be arranged regularly.

The electronic device may further include an interlayer insulating layer disposed between the third electrodes and the signal line and including an organic material, wherein contact holes among the contact holes may be defined by penetrating the interlayer insulating layer, and the third electrodes may be connected to the signal line through the contact holes.

The partition wall may include a first insulating pattern disposed on the pixel-defining layer, a second insulating pattern disposed on the first insulating pattern, a first partition wall pattern disposed on the second insulating pattern, and a second partition wall pattern disposed on the first partition wall pattern.

The first insulating pattern may include at least one of indium zinc oxide, indium gallium zinc oxide, or indium tin oxide, and the second insulating pattern may include at least one of silicon oxide, silicon oxynitride, or silicon nitride.

The first partition wall pattern may include aluminum, and the second partition wall pattern may include titanium.

A thickness of the first partition wall pattern may be greater than a thickness of the second partition wall pattern, a width of the second partition wall pattern may be greater than a width of the first partition wall pattern, and a portion of a lower surface of the second partition wall pattern may protrude from the first partition wall pattern and may be exposed from the first partition wall pattern.

The electronic device may further include a dummy pattern disposed on an upper surface of the second partition wall pattern, wherein the dummy pattern may include the same material as a common layer disposed between electrodes of light emitting elements of the pixels.

An electrode may extend from one of the light-emitting regions to the peripheral region and cover a side surface of the first partition wall pattern, the portion of the lower surface of the second partition wall pattern, and the dummy pattern.

The electronic device may further include an interlayer insulating layer disposed between the second pattern and the signal line and including an organic material, wherein contact holes are present penetrating the interlayer insulating layer and the pixel-defining layer, first and second insulating patterns of the second pattern, which are disposed in the contact holes, may include an insulating opening overlapping the contact holes, and the first partition wall pattern of the second pattern, which is disposed in the contact holes, may be connected to the signal line through the insulating opening and the contact holes.

The pixels may include a first pixel providing red light, a second pixel spaced apart from the first pixel along a first direction and providing blue light, and third and fourth pixels disposed between the first pixel and the second pixel, spaced apart from each other along a second direction crossing the first direction, and providing green light.

The light-emitting regions may include a first light-emitting region overlapping the first pixel, a second light-emitting region overlapping the second pixel, and third and fourth light-emitting regions overlapping the third and fourth pixels, and an area of the first light-emitting region may be smaller than an area of the second light-emitting region and larger than an area of each of the third and fourth light-emitting regions.

The electronic device may further include a spacer disposed on the pixel-defining layer, where at least a portion of the space is surrounded by the partition wall, and spaced apart from the partition wall, wherein a thickness of the partition wall from an upper surface of the pixel-defining layer may be smaller than a thickness of the spacer from the upper surface of the pixel-defining layer.

According to an embodiment, a display device is provided. The display device includes a display panel having a display region and a non-display region adjacent to the display region. The non-display region includes a driver region having a driver circuit. The display panel further includes: a substrate including light-emitting regions disposed in the display region and a peripheral region disposed between the light-emitting regions; a plurality of pixels overlapping the display region; a pixel-defining layer overlapping the peripheral region and including openings exposing at least portions of the light-emitting regions; a partition wall disposed on the pixel-defining layer, the partition wall including a first pattern having a lattice shape in the display region that overlaps the pixels and a second pattern extending from the first pattern into the non-display region and having protrusions extending from an outer part of the lattice shape in the non-display region to the driver region; and a protective electrode disposed in the driver region and electrically connected to the second pattern and to a power line configured to supply a predetermined voltage to protect the driver circuit.

According to an embodiment, an electronic device is provided. The electronic device includes a display panel and a voltage generator. The display panel includes a display region and a non-display region adjacent to the display region. The non-display region further includes a driver region having a driver circuit. The display panel further includes: a substrate including light-emitting regions disposed in the display region and a peripheral region disposed between the light-emitting regions; a plurality of pixels overlapping the display region; a pixel-defining layer overlapping the peripheral region and including openings exposing at least portions of the light-emitting regions; a partition wall disposed on the pixel-defining layer, the partition wall including a first pattern having a lattice shape in the display region that overlaps the pixels and a second pattern extending from the first pattern into the non-display region and having protrusions extending from an outer part of the lattice shape in the non-display region to the driver region; and a protective electrode disposed in the driver region and electrically connected to the second pattern. The voltage generator is configured to provide a supply voltage to the protective electrode and to the plurality of pixels.

According to at least one embodiment of an electronic device, a partition wall is provided in a display region of the electronic device to isolate electrodes from one another to reduce interference and increase signal stability. In a further embodiment, a driver (e.g., a scan driver) in a non-display region of the electronic device is protected from external electrical noise or electrostatic discharge by its overlap with a protective electrode connected to the partition wall that receives an equivalent voltage (e.g., a voltage equivalent to or the same as a voltage used to operate or drive another component in a display region of the electronic device).

### BRIEF DESCRIPTION OF THE DRAWINGS

FIG. 1A is a block diagram of an electronic device according to an embodiment of the present inventive concept;
FIG. 1B is schematic views of electronic devices according to various embodiments of the present inventive concept;
FIG. 1C is a perspective view of an electronic device according to an embodiment of the present inventive concept;
FIG. 2 is a cross-sectional view of an electronic device according to an embodiment of the present inventive concept;
FIG. 3 is a cross-sectional view of a display panel according to an embodiment of the present inventive concept;
FIG. 4A is a block diagram of a display module according to an embodiment of the present inventive concept;
FIG. 4B is an equivalent circuit of one pixel among pixels illustrated in FIG. 4A;
FIG. 5 is a plan view of a display region according to an embodiment of the present inventive concept;
FIG. 6 is a cross-sectional view taken along I-I' of FIG. 5;
FIG. 7 is a cross-sectional view taken along II-II' of FIG. 5;
FIG. 8A is a cross-sectional view taken along III-III' of FIG. 5;
FIG. 8B is a cross-sectional view of a display region according to an embodiment of the present inventive concept;
FIG. 9 is a plan view of a display panel according to an embodiment of the present inventive concept;
FIG. 10 is a cross-sectional view taken along IV-IV' of FIG. 9;
FIG. 11 is a cross-sectional view taken along V-V' of FIG. 9;
FIG. 12 is a cross-sectional view taken along VI-VI' of FIG. 9; and
FIG. 13 is a plan view of a display panel according to an embodiment of the present inventive concept.

### DETAILED DESCRIPTION

It is to be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols refer to like elements throughout. In the drawings, measures such as the thickness, ratio, and size of the elements represent example embodiments, but these measures may varied in alternate embodiments. As used herein, the term "and/or" includes any and all combinations of one or more of the associated listed elements.

It will be understood that, although the terms "first", "second", etc. may be used herein to describe various elements, the elements are not to be limited by these terms. These terms are only used to distinguish one element from another element. For instance, a first element discussed below could be termed a second element without departing from the scope of the present inventive concept. Similarly, a second element could be termed a first element. In this specification, the singular expressions "a", "an" and "the" are intended to include the plural forms as well, unless the context clearly indicates otherwise.

In addition, the terms "below", "under", "on the lower side", "above", "over", "on the upper side", or the like may be used to describe the relationships between the elements illustrated in the drawings. These terms are relative concepts and are described on the basis of the directions indicated in the drawings.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Hereinafter, embodiments of the present inventive concept are described with reference to the drawings.

At least one embodiment relates to a display device that enhances signal stability and pixel driving uniformity, and an electronic device including the display device. A partition wall may be provided in a display region of the display device to isolate electrodes from one another, thereby reducing interference and enhancing signal integrity. In addition, a protective electrode may be disposed in a non-display region of the display device to overlap a driver (e.g., a scan driver) used to drive pixels of the display device. The protective electrode may be connected to the partition wall for receiving an equivalent voltage. The equivalent voltage may be the same or equivalent voltage used to operate the display device or to drive pixels of the display device. This configuration may protect the driver from external electrical noise or electrostatic discharge and ensure that a uniform driving voltage is supplied to pixels in the display region.

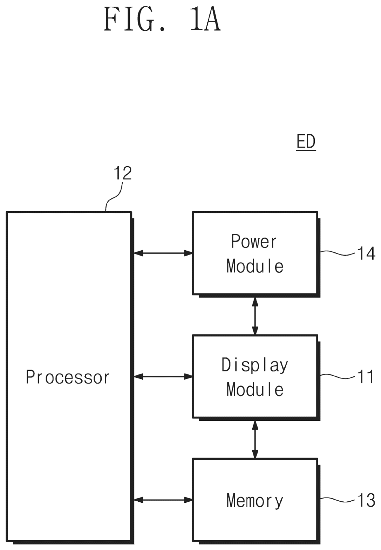

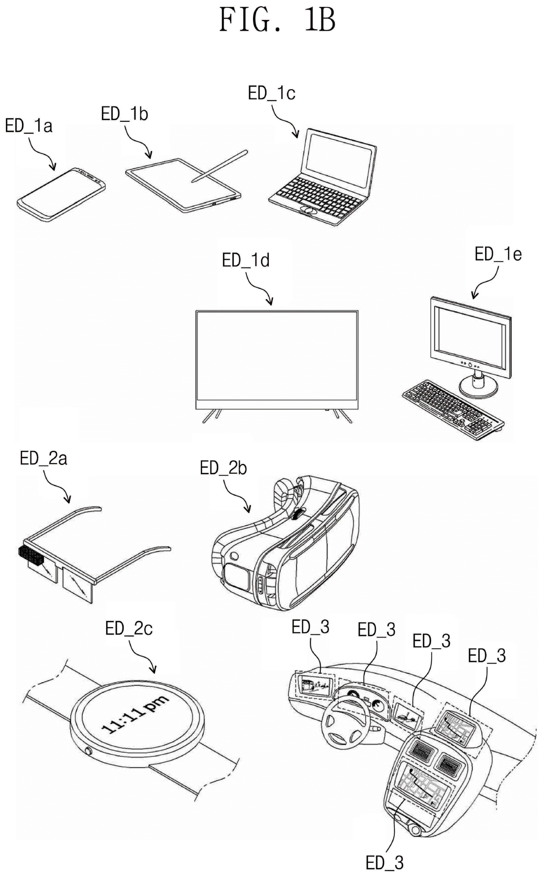

FIG. 1A is a block diagram of an electronic device according to an embodiment. FIG. 1B is schematic views of electronic devices according to various embodiments.

Referring to FIG. 1A, an electronic device ED according to an embodiment may include a display module 11, a processor 12, a memory 13, and a power module 14.

The processor 12 may include at least one among a central processing unit (CPU), an application processor (AP), a graphic processing unit (GPU), a communication processor (CP), an image signal processor (ISP) and a controller.

Data information required for an operation of the processor 12 or the display module 11 may be stored in the memory 13. When the processor 12 executes an application stored in the memory 13, an image data signal and/or an input control signal may be transferred to the display module 11, and the display module 11 may process the provided signal and output image information through a display screen.

The power module 14 may include a power supply module such as a power adapter or a battery device and a power conversion module which converts power supplied by the power supply module and generates power required for an operation of the electronic device ED.

At least one of each of the components of the electronic device ED described above may be included in a display device according to the embodiments described above. In addition, some of individual modules functionally included in one module may be included in the display device, and the others may be provided separately from the display device. For example, the display device may include the display module 11, and the processor 12, the memory 13 and the power module 14 may be provided in a form of another device in the electronic device ED, not the display device.

Referring to FIG. 1B, various electronic devices to which a display device according to embodiments is applied may include not only an electronic device for displaying images, such as a smartphone ED_1a, a tablet PC ED_1b, a laptop computer ED_1c, a TV ED_1d and a desk monitor ED_1e but also a wearable electronic device including a display module, such as smart glasses ED_2a, a head-mounted display ED_2b and a smart watch ED_2c, automotive electronic devices ED_3 including a display module, such as a center information display (CID) disposed on an instrument panel, center fascia, and a dashboard of an automobile and a room mirror display, etc.

The display device according to an embodiment may be applied to various electronic devices. The electronic device according to an embodiment may include the display device described above and may further include another module or device having an additional function in addition to the display device.

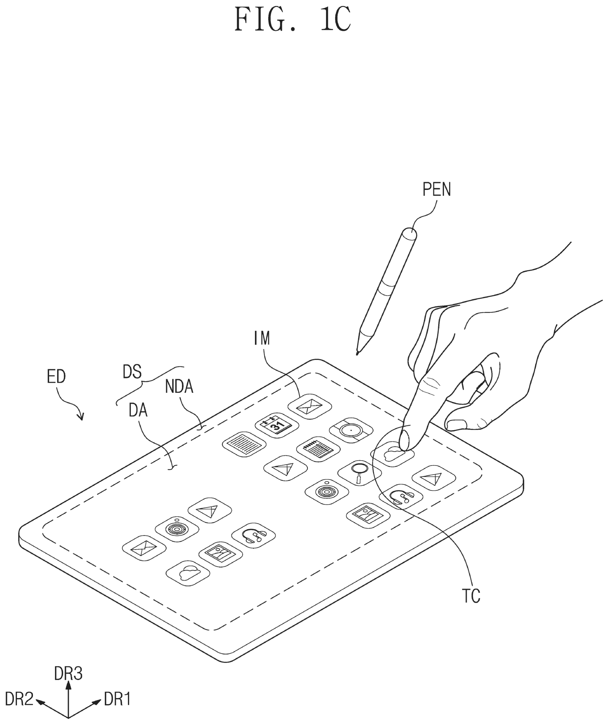

FIG. 1C is a perspective view of an electronic device according to an embodiment of the present inventive concept. The electronic devices described in FIGS. 1A and 1B may be applied to an electronic device ED to be described in FIG. 1C. For example, the smartphone ED_1a described in FIG. 1B may correspond to the electronic device ED of FIG. 1C.

Referring to FIG. 1C, the electronic device ED according to an embodiment of the present inventive concept may have long sides extending parallel in a first direction DR1 and short sides extending parallel in a second direction DR2 crossing the first direction DR1. Corners of the electronic device ED, which connect the long sides and the short sides, may have a curve shape. The corners of the electronic device ED, which have a curve shape, may be defined as rounded corners. Such a shape of the electronic device ED may be defined as a rounded-cornered quadrangle. However, this is merely an example of a shape of one electronic device ED, which is not limited to a rounded-cornered quadrangle.

Hereinafter, a direction substantially perpendicularly crossing a plane defined by the first direction DR1 and the second direction DR2 is defined as a third direction DR3. In addition, the term "in a plan view" herein may indicate a state of being viewed in the third direction DR3.

A front surface of the electronic device ED may be defined as a display surface DS, and the display surface DS may have a plane defined by the first direction DR1 and the second direction DR2. Images IM generated in the electronic device ED may be provided to a user through the display surface DS.

The display surface DS may include a display region DA and a non-display region NDA around the display region DA. The display region DA may display an image, and the non-display region NDA may not display an image. The non-display region NDA may surround the display region DA and define an edge of the electronic device ED, which is printed in a predetermined color.

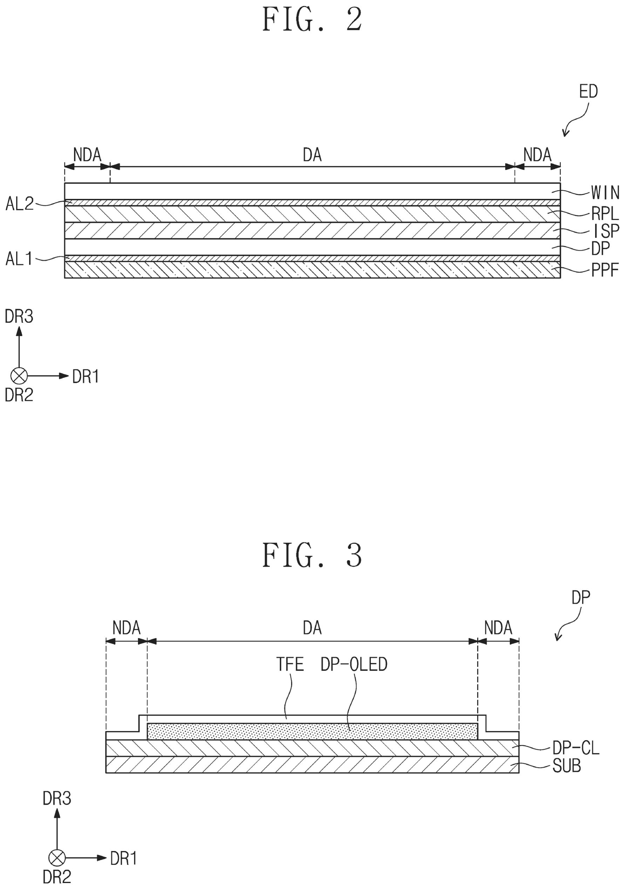

The display region DA may have a shape of a rounded-cornered quadrangle according to a shape of the electronic device ED. For example, the display region DA may include sides of a quadrangle extending in the first direction DR1 and the second direction DR2 and rounded corners connecting the sides. Sides extending in the first direction DR1 among the four sides may be defined as long sides, and sides extending in the second direction DR2 among the four sides may be defined as short sides. The non-display region NDA may be a region in which signal lines and driving elements for driving a display panel DP (see FIG. 2) included in the electronic device ED are disposed.

The electronic device ED may sense inputs applied from outside the electronic device ED. For example, the electronic device ED may sense a first input by a touch pen PEN or a second input by a touch TC. The touch pen PEN may be defined as an input device.

The touch pen PEN may be an active pen which outputs a signal. The second input by the touch TC may include various types of external inputs such as part of a user's body, light, heat or pressure.

The electronic device ED and the touch pen PEN may communicate bidirectionally. The electronic device ED may provide an uplink signal to the touch pen PEN. For example, the uplink signal may include information such as panel information and protocol version but is not particularly limited thereto.

The touch pen PEN may provide a downlink signal to the electronic device ED. The downlink signal may include synchronization signal or state information of the touch pen PEN. For example, the downlink signal may include coordinate information of the touch pen PEN, battery information of the touch pen PEN, inclination information of the touch pen PEN, a variety of information stored in the touch pen PEN, and/or the like, but is not particularly limited thereto.

The electronic device ED may be used in large-sized electronic devices such as televisions, monitors, or outdoor billboards. In addition, the electronic device ED may be used in small- and medium-sized electronic devices such as personal computers, laptop computers, personal digital terminals, automobile navigation devices, game consoles, smartphones, tablet computers or cameras. However, these are simply presented as example embodiments, and the electronic device ED may be used in other electronic apparatuses as well unless departing from the concept of the present inventive concept.

FIG. 2 is a cross-sectional view of an electronic device according to an embodiment of the present inventive concept. FIG. 3 is a cross-sectional view of a display panel according to an embodiment of the present inventive concept.

FIG. 2 is a diagram illustrating a cross section of the electronic device illustrated in FIG. 1C as an example. In FIG. 2, a cross section of the electronic device ED viewed in the second direction DR2 is illustrated as an example.

Referring to FIG. 2, the electronic device ED may include a display panel DP, an input sensor ISP, an anti-reflective layer RPL, a window WIN, a panel protective film PPF and first and second adhesive layers AL1 and AL2.

The display panel DP according to an embodiment of the present inventive concept may be an emissive display panel. For example, the display panel DP may be an organic light-emitting display panel or an inorganic light-emitting display panel. An emission layer of the organic light-emitting display panel may include an organic light-emitting material. An emission layer of the inorganic light-emitting display panel may include quantum dots, quantum rods, and the like. Hereinafter, the display panel DP is described as an organic light-emitting display panel.

The input sensor ISP may be disposed on the display panel DP. The input sensor ISP may include a plurality of sensing parts (not illustrated) for sensing an external input in a capacitive manner. The input sensor ISP may be directly manufactured on the display panel DP when the electronic device ED is manufactured. Thus, the input sensor ISP according to an embodiment may be directly disposed on the display panel DP. However, the input sensor ISP is not limited thereto and may be manufactured as a panel separate from the display panel DP and may be attached to the display panel DP through an adhesive layer.

The anti-reflective layer RPL may be disposed on the input sensor ISP. The anti-reflective layer RPL may be directly manufactured on the input sensor ISP when the electronic device ED is manufactured. However, the anti-reflective layer RPL is not limited thereto and may be manufactured as a separate panel and attached to the input sensor ISP through an adhesive layer.

The anti-reflective layer RPL may be defined as an external light anti-reflective film. The anti-reflective layer RPL may reduce reflectance of external light incident toward the display panel DP from above the electronic device ED. The external light may not be viewed by a user due to the anti-reflective layer RPL.

When external light travels toward the display panel DP, reflects off the display panel DP, and returns to a user, the user may perceive the reflected light as if viewing a mirror. By way of example, the anti-reflective layer RPL may include a plurality of color filters which display the same color as pixels of the display panel DP to prevent this phenomenon.

The color filters may filter external light having the same color as the pixels. In this case, the external light may not be visible by a user. However, the anti-reflective layer RPL is not limited to this configuration and may include a retarder and/or a polarizer to reduce reflectance of external light.

The window WIN may be disposed on the anti-reflective layer RPL. The window WIN may protect the display panel DP, the input sensor ISP and the anti-reflective layer RPL from external scratches and impacts.

The panel protective film PPF may be disposed below the display panel DP. The panel protective film PPF may protect a lower portion of the display panel DP. The panel protective film PPF may include a flexible plastic material such as polyethyleneterephthalate (PET).

The first adhesive layer AL1 may be disposed between the display panel DP and the panel protective film PPF, and the display panel DP and the panel protective film PPF may be bonded to each other through the first adhesive layer AL1. The second adhesive layer AL2 may be disposed between the window WIN and the anti-reflective layer RPL, and the window WIN and the anti-reflective layer RPL may be bonded to each other through the second adhesive layer AL2.

According to at least one embodiment, a sensor may be disposed below the display panel DP to overlap the display region DA. The sensor may include at least one among a camera sensor, a speaker sensor, an IR sensor, an illuminance sensor, and a thermal sensor.

FIG. 3 is a diagram illustrating a cross section of the display panel illustrated in FIG. 2 as an example. In FIG. 3, a cross section of the display panel DP viewed in the second direction DR2 is illustrated as an example.

Referring to FIG. 3, the display panel DP may include a substrate SUB, a circuit element layer DP-CL disposed on the substrate SUB, a display element layer DP-OLED disposed on the circuit element layer DP-CL, and a thin-film encapsulation layer TFE disposed on the display element layer DP-OLED.

The substrate SUB may include a display region DA and a non-display region NDA around the display region DA. The substrate SUB may include glass or include a flexible plastic material such as polyimide. The display element layer DP-OLED may be disposed on the display region DA.

A plurality of pixels may be disposed in the circuit element layer DP-CL and the display element layer DP-OLED. The pixels may each include a transistor disposed in the circuit element layer DP-CL and a light-emitting element disposed in the display element layer DP-OLED and connected to the transistor.

The thin-film encapsulation layer TFE may be disposed on the circuit element layer DP-CL so as to cover the display element layer DP-OLED. The thin-film encapsulation layer TFE may protect the pixels from moisture, oxygen and external foreign substances.

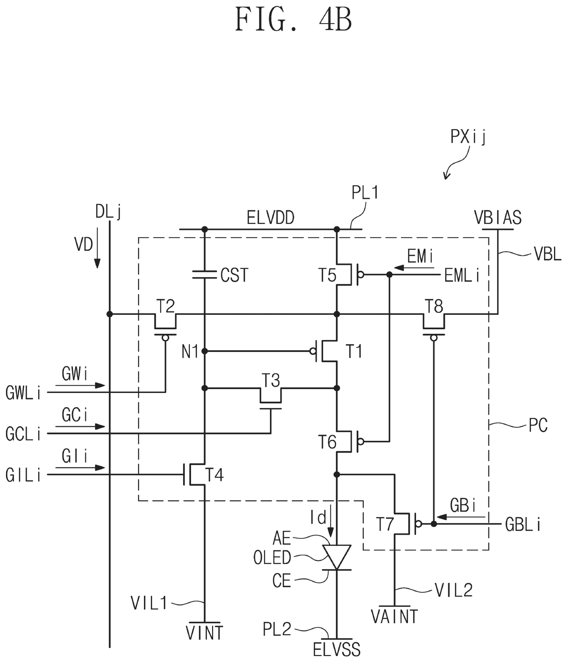

The thin-film encapsulation layer TFE may be disposed on a light-emitting element OLED-G1 and cover the light-emitting element OLED-G1. The thin-film encapsulation layer TFE may include a first inorganic layer LIL disposed on pixels PXij (see FIG. 4B), a second inorganic layer UIL disposed on the first inorganic layer LIL and an organic layer OL disposed between the first and second inorganic layers LIL and UIL.

The first and second inorganic layers LIL and UIL may include an inorganic material and protect the pixels from moisture/oxygen. The organic layer OL may include an organic material and protect the pixels PXij (seeFIG. 4B) from foreign substances such as dust particles. The organic layer OL may be formed through a solution process such as spin coating, slit coating, and an inkjet process.

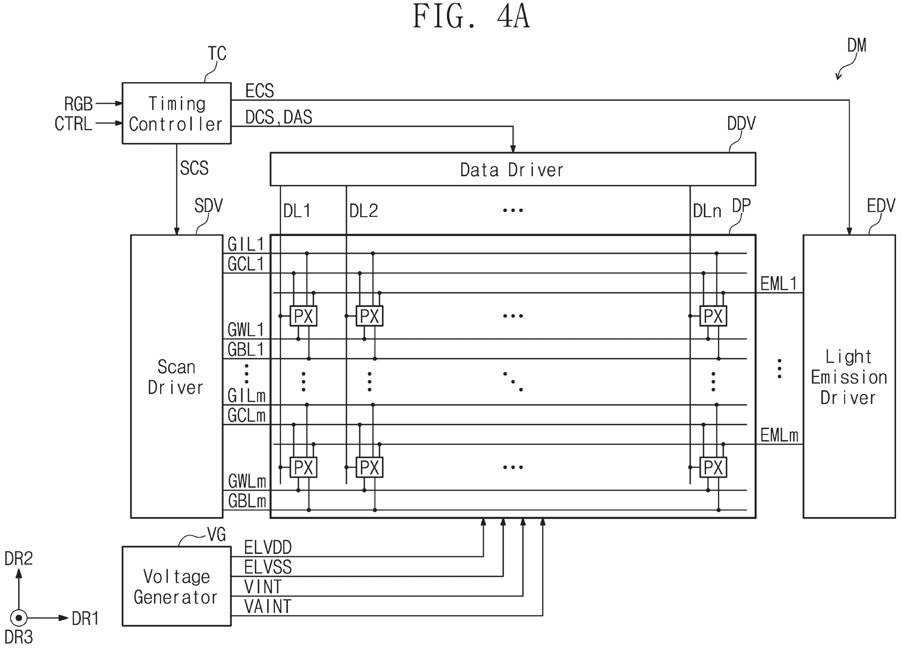

FIG. 4A is a block diagram of a display module according to an embodiment of the present inventive concept.FIG. 4B is an equivalent circuit of one pixel among pixels illustrated in FIG. 4A.

Referring to FIG. 4A, the electronic device ED may include the display panel DP, a timing controller TC (e.g., a control circuit), a scan driver SDV (e.g., a first driver circuit), a data driver DDV (e.g., a second driver circuit), a light emission driver EDV (e.g., a third driver circuit) and a voltage generator VG.

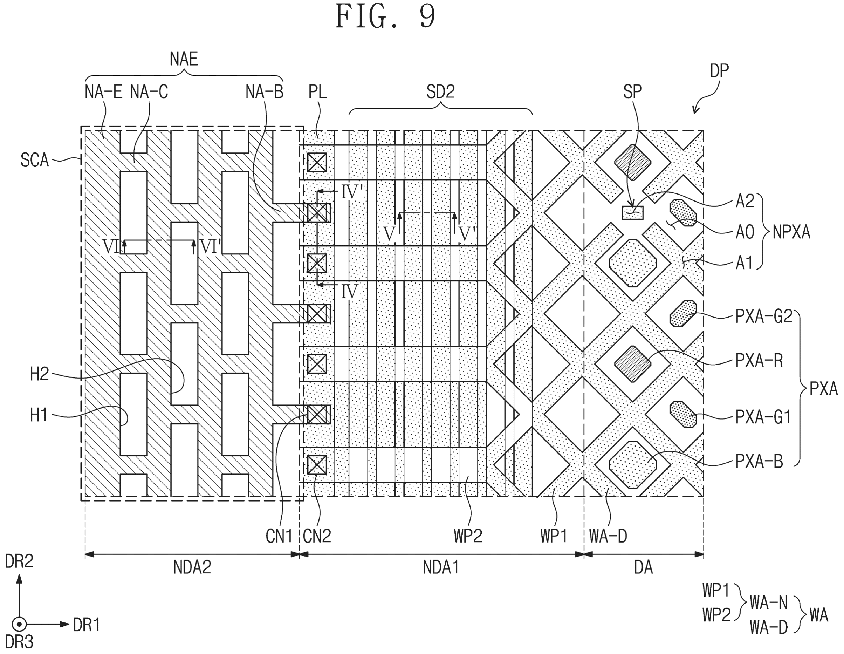

According to an embodiment, the scan driver SDV may be disposed in the non-display region NDA of the display panel DP described in FIG. 3. According to the present embodiment, a region of the non-display region NDA, in which the scan driver SDV is disposed, may be defined as a scan region SCA (see FIG. 9).

The scan driver SDV may include a plurality of transistors. The scan driver SDV disposed in the non-display region NDA may be exposed to external electrical stimuli and thus may require protection from such electrical influences.

According to an embodiment, a protective electrode NAE (see FIG. 9) to which an equivalent voltage is applied to protect the scan driver SDV from external electrical stimuli, may be disposed in the scan region SCA (see FIG. 9). A detailed description thereof will be provided later.

The display panel DP may include a plurality of scan lines GIL1 to GILm, GCL1 to GCLm, GWL1 to GWLm and GBL1 to GBLm, a plurality of light emission lines EML1 to EMLm, a plurality of data lines DL1 to DLn and a plurality of pixels PX. Here, m and n may be natural numbers.

Each of the pixels PX may be electrically connected to the scan lines GIL1 to GILm, GCL1 to GCLm, GWL1 to GWLm and GBL1 to GBLm, the light emission lines EML1 to EMLm, and the data lines DL1 to DLn. Each of the pixels PX may be electrically connected to four corresponding scan lines, one corresponding data line and one corresponding light emission line.

The scan lines GIL1 to GILm, GCL1 to GCLm, GWL1 to GWLm and GBL1 to GBLm may include a plurality of initialization scan lines GIL1 to GILm, a plurality of compensation scan lines GCL1 to GCLm, a plurality of write scan lines GWL1 to GWLm and a plurality of bias scan lines GBL1 to GBLm.

Each of the pixels PX may be connected to corresponding one of the initialization scan lines GIL1 to GILm, corresponding one of the compensation scan lines GCL1 to GCLm, corresponding one of the write scan lines GWL1 to GWLm and corresponding one of the bias scan lines GBL1 to GBLm.

The scan lines GIL1 to GILm, GCL1 to GCLm, GWL1 to GWLm and GBL1 to GBLm may be connected to the scan driver SDV, extend in the first direction DR1, and be arranged in the second direction DR2. The light emission lines EML1 to EMLm may be connected to the light emission driver EDV, extend in the first direction DR1, and be arranged in the second direction DR2. The data lines DL1 to DLn may be connected to the data driver DDV, extend in the second direction DR2, and be arranged in the first direction DR1.

The scan driver SDV, the light emission driver EDV and the data driver DDV may be disposed substantially in the display panel DP.

The timing controller TC may receive an image signal RGB and a control signal CTRL. The timing controller TC may generate an image data signal DAS by converting a data format of the image signal RGB to comply with interface specifications of the data driver DDV. The timing controller TC may output a scan control signal SCS, a data control signal DCS and a light emission control signal ECS in response to the control signal CTRL.

The voltage generator VG may generate voltages used in an operation of the display panel DP. The voltage generator VG may generate a first driving voltage ELVDD, a second driving voltage ELVSS, a first initialization voltage VINT and a second initialization voltage VAINT. The first driving voltage ELVDD, the second driving voltage ELVSS, the first initialization voltage VINT and the second initialization voltage VAINT may be applied to the pixels PX.

The scan driver SDV may receive the scan control signal SCS from the timing controller TC. The scan driver SDV may output scan signals to the scan lines GIL1 to GILm, GCL1 to GCLm, GWL1 to GWLm and GBL1 to GBLm in response to the scan control signal SCS. The scan signals may be applied to the pixels PX through the scan lines GIL1 to GILm, GCL1 to GCLm, GWL1 to GWLm and GBL1 to GBLm.

The data driver DDV may receive the data control signal DCS and the image data signal DAS from the timing controller TC. The data driver DDV may convert the image data signal DAS into data signals and output the data signals. The data signals may be defined as analog voltages corresponding to a grayscale level of the image data signal DAS. The data signals may be applied to the pixels PX through the data lines DL1 to DLn.

The light emission driver EDV may receive the light emission control signal ECS from the timing controller TC. The light emission driver EDV may output light emission signals to the light emission lines EML1 to EMLm in response to the light emission control signal ECS. The light emission signals may be applied to the pixels PX through the light emission lines EML1 to EMLm.

The pixels PX may receive data voltages in response to the scan signals and display an image by emitting light with luminance corresponding to the data voltages in response to the light emission signals.

FIG. 4B is a diagram illustrating an equivalent circuit of one pixel among the pixels illustrated in FIG. 4A.

By way of example, a pixel PXij connected to a j-th data line DLj, i-th scan lines GWLi, GCLi, GILi and GBLi, and an i-th light emission line EMLi is illustrated in FIG. 4B. Here, i and j may be natural numbers.

Referring to FIG. 4B, the pixel PXij may include a pixel circuit PC and a light-emitting element OLED-G1 connected to the pixel circuit PC. The pixel circuit PC may drive the light-emitting element OLED-G1.

The pixel circuit PC may include a plurality of transistors T1 to T8 and a capacitor CST. The transistors T1 to T8 and the capacitor CST may control the amount of current flowing in the light-emitting element OLED-G1. The light-emitting element OLED-G1 may generate light having a predetermined luminance according to the amount of received current.

An i-th write scan line GWLi may receive an i-th write scan signal GWi, and an i-th compensation scan line GCLi may receive an i-th compensation scan signal GCi. An i-th initialization scan line GILi may receive an i-th initialization scan signal GIi, and an i-th bias scan line GBLi may receive an i-th bias scan signal GBi. The i-th light emission line EMLi may receive an i-th light emission signal EMi.

The pixel PXij may be connected to the j-th data line DLj, the i-th write scan line GWLi, the i-th compensation scan line GCLi, the i-th initialization scan line GILi, the i-th bias scan line GBLi, the i-th light emission line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

The transistors T1 to T8 may each include a source electrode, a drain electrode, and a gate electrode. Hereinafter, in FIG. 4B, for convenience, one of a source electrode and a drain electrode is referred to as a first electrode, and the other is referred to as a second electrode. In addition, a gate electrode may be referred to as a control electrode.

The transistors T1 to T8 may include first to eighth transistors T1 to T8. The first, second, and fifth to eighth transistors T1, T2 and T5 to T8 may be PMOS transistors. The third and fourth transistors T3 and T4 may be NMOS transistors.

The first transistor T1 may be referred to as a driving transistor, and the second transistor T2 may be referred to as a switching transistor. The third transistor T3 may be referred to as a compensation transistor. The fourth transistor T4 and the seventh transistor T7 may each be referred to as an initialization transistor. The fifth transistor T5 and the sixth transistor T6 may each be referred to as a light emission control transistor. The eighth transistor T8 may be referred to as a bias transistor.

The light-emitting element OLED may be defined as an organic light-emitting element. The light-emitting element OLED may include a first electrode AE and a second electrode CE. The first electrode AE may receive the first driving voltage ELVDD through the sixth, first, and fifth transistors T6, T1, and T5. The first driving voltage ELVDD may be applied to the pixel circuit PC through the first power line PL1.

The second electrode CE may receive the second driving voltage ELVSS having a lower level than the first driving voltage ELVDD. The second driving voltage ELVSS may be applied to the pixel circuit PC through the second power line PL2.

The first transistor T1 may be disposed between the fifth transistor T5 and the sixth transistor T6 and connected to the fifth transistor T5 and the sixth transistor T6. The first transistor T1 may be connected to the first power line PL1 through the fifth transistor T5 and connected to the first electrode AE through the sixth transistor T6.

The first transistor T1 may include a first electrode connected to the first power line PL1 through the fifth transistor T5, a second electrode connected to the first electrode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing in the light-emitting element OLED according to a voltage of the first node N1 applied to the control electrode of the first transistor T1.

The second transistor T2 may be disposed between the first transistor T1 and the j-th data line DLj and connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on by the i-th write scan signal GWi applied through the i-th write scan line GWLi and electrically connect the j-th data line DLj and the first electrode of the first transistor T1. The second transistor T2 may perform a switching operation to provide a data voltage VD (corresponding to the data signal described above), which is applied through the j-th data line DLj, to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a control electrode connected to the i-th compensation scan line GCLi.

The third transistor T3 may be turned on by the i-th compensation scan signal GCi applied through the i-th compensation scan line GCLi and electrically connect the second electrode of the first transistor T1 and the control electrode of the first transistor T1. When the third transistor T3 is turned on, the first transistor T1 and the third transistor T3 may be diode-connected.

The fourth transistor T4 may be connected to the first node N1. The fourth transistor T4 may include a first electrode connected to the first node N1, a second electrode connected to the first initialization line VIL1, and a control electrode connected to the i-th initialization scan line GILi. The fourth transistor T4 may be turned on by the i-th initialization scan signal GIi applied through the i-th initialization scan line GILi and provide the first initialization voltage VINT applied through the first initialization line VIL1 to the first node N1.

The fifth transistor T5 may include a first electrode connected to the first power line PL1, a second electrode connected to the first electrode of the first transistor T1, and a control electrode connected to the i-th light emission line EMLi.

The sixth transistor T6 may include a first electrode connected to the second electrode of the first transistor T1, a second electrode connected to the first electrode AE, and a control electrode connected to the i-th light emission line EMLi.

The fifth transistor T5 and the sixth transistor T6 may be turned on by the i-th light emission signal EMi applied through the i-th light emission line EMLi. The first driving voltage ELVDD may be provided to the light-emitting element OLED by the turned-on fifth transistor T5 and sixth transistor T6, and driving current may flow in the light-emitting element OLED. Thus, the light-emitting element OLED may emit light.

The seventh transistor T7 may include a first electrode connected to the first electrode AE, a second electrode connected to the second initialization line VIL2, and a control electrode connected to the i-th bias scan line GBLi. The seventh transistor T7 may be turned on by the i-th bias scan signal GBi applied through the i-th bias scan line GBLi, and may provide the second initialization voltage VAINT which is received through the second initialization line VIL2 to the first electrode AE of the light-emitting element OLED.

In an embodiment, the second initialization voltage VAINT may have a different level from the first initialization voltage VINT but is not limited thereto and may have the same level as the first initialization voltage VINT.

The seventh transistor T7 may enhance black expression capability of the pixel PXij. When the seventh transistor T7 is turned on, a parasitic capacitance of the light-emitting element OLED may be discharged. Thus, when black luminance is implemented, the light-emitting element OLED may not emit light due to leakage current of the first transistor T1, and accordingly, the black expression capability may be enhanced.

The capacitor CST may include a first electrode connected to the first power line PL1 and a second electrode connected to the first node N1. When the fifth transistor T5 and the sixth transistor T6 are turned on, the amount of current flowing in the first transistor T1 may be determined according to a voltage stored in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on by the i-th bias scan signal GBi and provide the bias voltage VBIAS applied through the bias line VBL to the first electrode of the first transistor T1. However, the transistors included in the pixel PXij are not limited thereto.

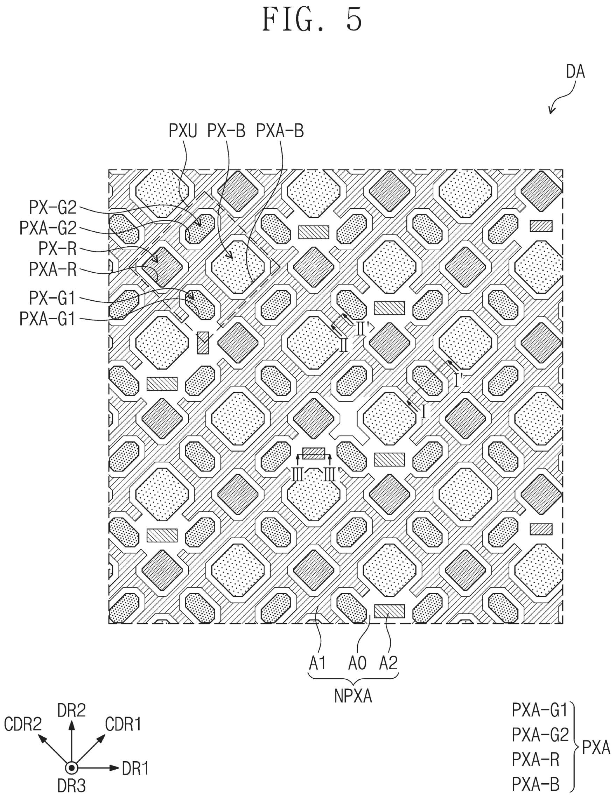

FIG. 5 is a plan view of a pixel unit according to an embodiment of the present inventive concept.

Referring to FIG. 5, in the present embodiment, one pixel unit PXU may include the pixels described in FIGS. 4A and 4B. The pixel unit PXU may be provided in plurality and arranged along the first and second directions DR1 and DR2 in a display region DA.

The pixel unit according to an embodiment may include first through (3-2)-th pixels PX-R, PX-B, PX-G1, and PX-G2.

The first pixel PX-R may provide red light. Light generated in the first pixel PX-R may be provided to the display region DA through a first light-emitting region PXA-R. The first light-emitting region PXA-R may be spaced apart from a second light-emitting region PXA-B along the first direction DR1. The first light-emitting region PXA-R may be spaced apart from a (3-1)-th light-emitting region PXA-G1 along a second diagonal direction CDR2, and may be spaced apart from a (3-2)-th light-emitting region PXA-G2 along a first diagonal direction CDR1. In the present embodiment, the first light-emitting region PXA-R may have a rhombic octagonal shape. According to an embodiment, the first light-emitting region PXA-R may have a circular shape or an oval shape.

The second pixel PX-B may provide blue light. Light generated in the second pixel PX-B may be provided to the display region DA through the second light-emitting region PXA-B. The second light-emitting region PXA-B may be spaced apart from the (3-1)-th light-emitting region PXA-G1 along the first diagonal direction CDR1, and may be spaced apart from the (3-2)-th light-emitting region PXA-G2 along the second diagonal direction CDR2. In the present embodiment, the second light-emitting region PXA-B may have a rhombic octagonal shape. According to an embodiment, the second light-emitting region PXA-B may have a circular shape or an oval shape.

The (3-1)-th pixel PX-G1 may provide green light. Light generated in the (3-1)-th pixel PX-G1 may be provided to the display region DA through the (3-1)-th light-emitting region PXA-G1. In the present embodiment, the (3-1)-th light-emitting region PXA-G1 may have an octagonal shape extending along the second diagonal direction CDR2. According to an embodiment, the (3-1)-th light-emitting region PXA-G1 may have a circular shape or an oval shape.

The (3-2)-th pixel PX-G2 may provide green light like the (3-1)-th pixel PX-G1. Light generated in the (3-2)-th pixel PX-G2 may be provided to the display region DA through the (3-2)-th light-emitting region PXA-G2. The (3-2)-th light-emitting region PXA-G2 may be spaced apart from the (3-1)-th light-emitting region PXA-G1 along the second direction DR2. In the present embodiment, the (3-2)-th light-emitting region PXA-G2 may have an octagonal shape extending along the first diagonal direction CDR1. According to an embodiment, the (3-2)-th light-emitting region PXA-G2 may have a circular shape or an oval shape.

According to an embodiment, an area of the first light-emitting region PXA-R may be larger than an area of each of the (3-1)-th and (3-2)-th light-emitting regions PXA-G1 and PXA-G2 and smaller than an area of the second light-emitting region PXA-B.

A region between the first to (3-2)-th light-emitting regions PXA-R, PXA-B, PXA-G1, and PXA-G2 may be defined as a peripheral region NPXA.

The peripheral region NPXA according to an embodiment may include a normal region A0, a partition wall region A1, and support regions A2. The partition wall region A1 and the support regions A2 may be surrounded by the normal region A0. The partition wall region A1 and the support regions A2 may be spaced apart from each other with the normal region A0 therebetween.

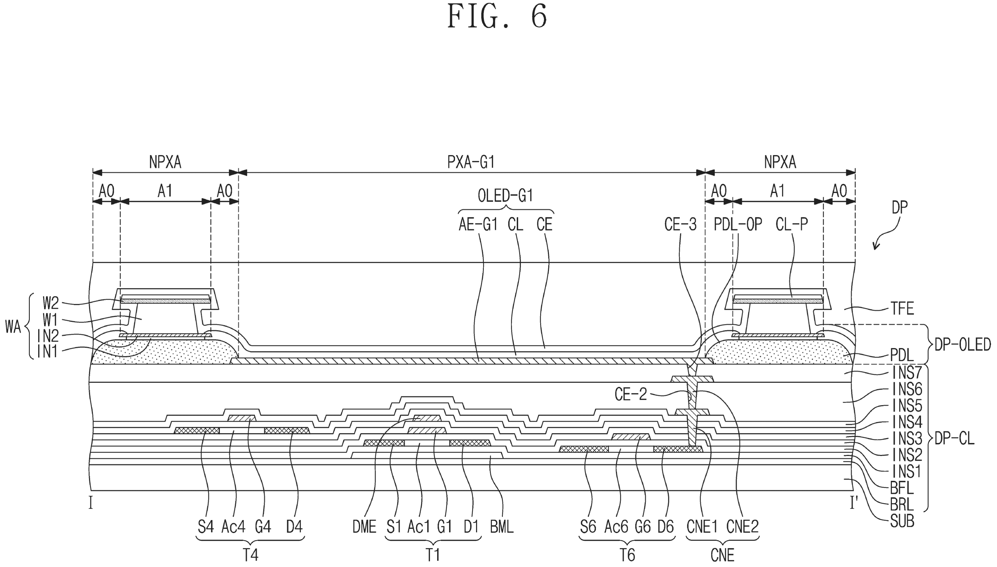

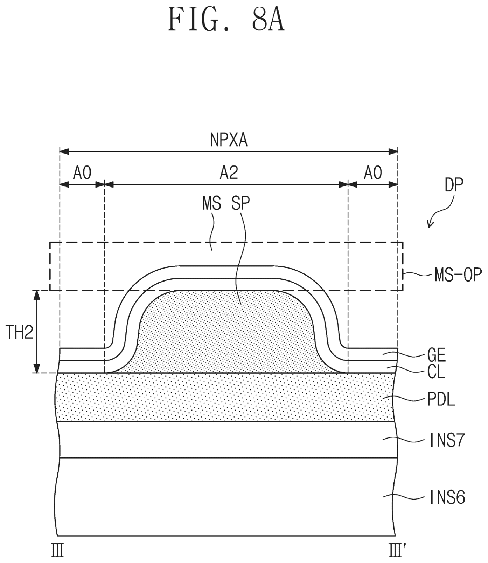

The partition wall region A1 may be defined as a region in which a partition wall WA (see FIG. 6) is disposed on a pixel-defining layer PDL (see FIG. 6). The support regions A2 may be defined as a region in which a spacer SP (see FIG. 8A) is disposed on the pixel-defining layer PDL (see FIG. 6). The spacer SP (see FIG. 8A) may be a structure that supports a mask MS (see FIG. 8A). A more detailed description will be provided later.

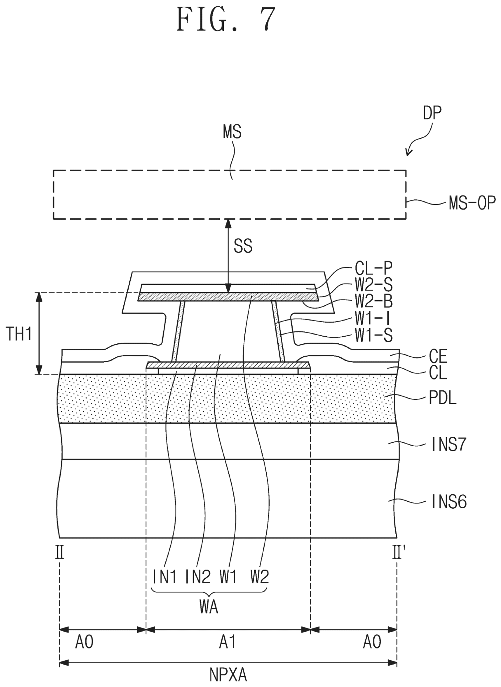

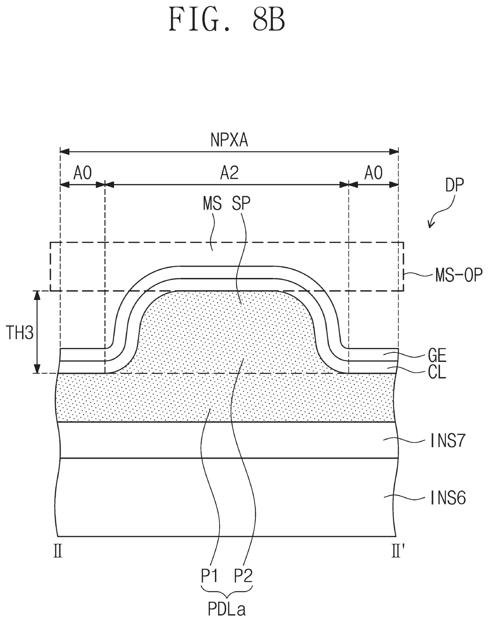

FIG. 6 is a cross-sectional view taken along I-I' of FIG. 5. FIG. 7 is a cross-sectional view taken along II-II' of FIG. 5. FIG. 8A is a cross-sectional view taken along III-III' of FIG. 5. FIG. 8B is a cross-sectional view of a display region according to an embodiment.

FIG. 6 illustrates a cross-sectional view of the (3-1)-th pixel PX-G1 and a region adjacent to the (3-1)-th pixel PX-G1in FIG. 5. Referring to FIG. 6, a light-emitting element OLED-G1 according to an embodiment may include a first electrode AE-G1, a second electrode CE, and a common layer CL. The common layer CL may include a hole control layer, an electron control layer, an emission layer, and the like.

The second electrode CE may be disposed on the first electrode AE-G1, and the common layer CL may be disposed between the first electrode AE-G1 and the second electrode CE. The light-emitting element OLED-G1 according to an embodiment may further include a protective layer disposed on the second electrode CE. The protective layer may include an organic material and prevent components disposed below the protective layer from being damaged in a subsequent process. According to an embodiment, the protective layer may be omitted.

First, fourth, and sixth transistors T1, T4, and T6 and the light-emitting element OLED-G1 may be disposed on a substrate SUB. The display region DA may include a first light-emitting region PXA corresponding to the pixel PXij (see FIG. 4B) and a peripheral region NPXA adjacent to the first light-emitting region PXA.

The substrate SUB may include glass or include a flexible plastic material such as polyimide (PI). A circuit element layer DP-CL, a display element layer DP-OLED, and a thin-film encapsulation layer TFE may be disposed on the substrate SUB. The circuit element layer DP-CL may be disposed on the substrate SUB. The circuit element layer DP-CL may include insulating layers and conductive patterns. The display element layer DP-OLED may include the light-emitting element OLED-G1 and a pixel-defining layer PDL.

A barrier layer BRL may be disposed on the substrate SUB. The barrier layer BRL may increase coupling force between the substrate SUB and a semiconductor pattern included in transistors. The barrier layer BRL may include an inorganic material.

A metal layer BML may be disposed on the barrier layer BRL. The metal layer BML may overlap the first transistor T1. According to an embodiment, the metal layer BML may receive a constant voltage or a direct current (DC) voltage. When the constant voltage is applied to the metal layer BML, a value of a threshold voltage Vth of the first transistor T1 disposed on the metal layer BML may be maintained without being changed.

The metal layer BML may block light incident from below the metal layer BML onto the first transistor T1. The metal layer BML may include reflective metal. According to an embodiment, the metal layer BML may be omitted.

A buffer layer BFL may be disposed on the barrier layer BRL and cover the metal layer BML. The buffer layer BFL may include an inorganic material.

A semiconductor layer S1, Ac1, and D1 of the first transistor T1 and a semiconductor layer S6, Ac6, and D6 of the sixth transistor T6 may be disposed on the buffer layer BFL. The semiconductor layers S1, Ac1, D1, S6, Ac6, and D6 may include polysilicon. However, the semiconductor layers S1, Ac1, D1, S6, Ac6, and D6 are not limited thereto and may include amorphous silicon.

The semiconductor layers S1, Ac1, D1, S6, Ac6, and D6 may be doped with an

N-type dopant or a P-type dopant. The semiconductor layers S1, Ac1, D1, S6, Ac6, and D6 may include a heavily doped region and a lightly doped region. Conductivity of the heavily doped region may be higher than the lightly doped region and may substantially serve as a source electrode and a drain electrode of the first and sixth transistors T1 and T6. The lightly doped region may substantially correspond to an active (or a channel) of the first and sixth transistors T1 and T6.

A first source region S1, a first channel region Ac1, and a first drain region D1 of the first transistor T1 may be formed from the semiconductor layer S1, Ac1, and D1. A sixth source region S6, a sixth channel region Ac6, and a sixth drain region D6 of the sixth transistor T6 may be formed from the semiconductor layer S6, Ac6, and D6. The first channel region Ac1 may be disposed between the first source region S1 and the first drain region D1. The sixth channel region Ac6 may be disposed between the sixth source region S6 and the sixth drain region D6.

A first insulating layer INS1 (e.g., a first interlayer insulating layer) may be disposed on the buffer layer BFL so as to cover the semiconductor layers S1, Ac1, D1, S6, Ac6, and D6. A first gate electrode G1 (or a control electrode) of the first transistor T1 and a sixth gate electrode G6 (or a control electrode) of the sixth transistor T6 may be disposed on the first insulating layer INS1. In a plan view, the first gate electrode G1 may overlap the first channel region Ac1, and the sixth gate electrode G6 may overlap the sixth channel region Ac6.

A structure of a source region, a channel region, a drain region, and a gate electrode of each of the second, fifth, and seventh transistors T2, T5, and T7 may be substantially the same as the first and sixth transistors T1 and T6.

A second insulating layer INS2 (e.g., a second interlayer insulating layer) may be disposed on the first insulating layer INS1 so as to cover the first and sixth gate electrodes G1 and G6. A dummy electrode DME may be disposed on the second insulating layer INS2. The dummy electrode DME may be disposed on the first gate electrode G1 and overlap the first gate electrode G1 in a plan view. The dummy electrode DME may form the capacitor described above together with the first gate electrode G1.

A third insulating layer INS3 (e.g., a third interlayer insulating layer) may be disposed on the second insulating layer INS2 so as to cover the dummy electrode DME. A semiconductor layer S4, Ac4, and D4 of the fourth transistor T4 may be disposed on the third insulating layer INS3. The semiconductor layer S4, Ac4, and D4 may include oxide semiconductor which is formed of metal oxide. The oxide semiconductor may include crystalline or amorphous oxide semiconductor.

The semiconductor layer S4, Ac4, and D4 may include a plurality of regions divided according to whether metal oxide is reduced. A region (hereinafter, a reduced region) in which metal oxide is reduced may have higher conductivity than a region (hereinafter, a non-reduced region) in which metal oxide is not reduced. The reduced region may substantially serve as a source electrode or a drain electrode of the fourth transistor T4. The non-reduced region may substantially correspond to an active (or a channel) of the fourth transistor T4.

A fourth source region S4, a fourth channel region Ac4, and a fourth drain region D4 of the fourth transistor T4 may be formed from the semiconductor layer S4, Ac4, and D4. The fourth channel region Ac4 may be disposed between the fourth source region S4 and the fourth drain region D4.

A fourth insulating layer INS4 (e.g., a fourth interlayer insulating layer) may be disposed on the third insulating layer INS3 so as to cover the semiconductor layer S4, Ac4, and D4. A fourth gate electrode G4 of the fourth transistor T4 may be disposed on the fourth insulating layer INS4. In a plan view, the fourth gate electrode G4 may overlap the fourth channel region Ac4.

A fifth insulating layer INS5 (e.g., a fifth interlayer insulating layer) may be disposed on the fourth insulating layer INS4 so as to cover the fourth gate electrode G4. A structure of a source region, a channel region, a drain region, and a gate electrode of the third transistor T3 may be substantially the same as the fourth transistor T4.

The barrier layer BRL, the buffer layer BFL, and the first to fifth insulating layers INS1 to INS5 may include an inorganic material. By way of example, the barrier layer BRL, the buffer layer BFL, and the first to fifth insulating layers INS1 to INS5 may include one of silicon oxide and silicon nitride, or one insulating layer may include multilayered inorganic layers and is not limited to any one embodiment. The multilayered inorganic layers may have a structure in which layers including silicon nitride and silicon oxide are alternately stacked. According to an embodiment, an insulating layer including an inorganic material may be additionally disposed in addition to the first to fifth insulating layers INS1 to INS5, or one of the first to fifth insulating layers INS1 to INS5 may be omitted.

A connection electrode CNE may be disposed between the sixth transistor T6 and the light-emitting element OLED-G1. The connection electrode CNE may electrically connect the sixth transistor T6 and the light-emitting element OLED-G1. The connection electrode CNE may include a first connection electrode CNE1 and a second connection electrode CNE2 disposed on the first connection electrode CNE1.

The first connection electrode CNE1 may be disposed on the fifth insulating layer INS5 and connected to the sixth drain region D6 through a first contact hole CH1 defined in the first to fifth insulating layers INS1 to INS5. A sixth insulating layer INS6 (e.g., a sixth interlayer insulating layer) may be disposed on the fifth insulating layer INS5 so as to cover the first connection electrode CNE1.

The second connection electrode CNE2 may be disposed on the sixth insulating layer INS6. The second connection electrode CNE2 may be connected to the first connection electrode CNE1 through a second contact hole CH2 defined in the sixth insulating layer INS6.

A seventh insulating layer INS7 (e.g., a seventh interlayer insulating layer) may be disposed on the sixth insulating layer INS6 so as to cover the second connection electrode CNE2 and a first power line ES. The sixth and seventh insulating layers INS6 and INS7 may include an organic material. According to an embodiment, an insulating layer including an organic material may be additionally disposed in addition to the sixth and seventh insulating layers INS6 and INS7, or one of the sixth and seventh insulating layers INS6 and INS7 may be omitted.

The pixel-defining layer PDL may be disposed on the seventh insulating layer INS7. An opening PDL-OP exposing at least a portion of the first electrode AE-G1 may be defined in the pixel-defining layer PDL. The opening PDL-OP may be provided in plurality according to the number of the first electrode AE-G1, and the openings PDL-OP may correspond to the first to (3-2)-th light-emitting regions PXA-R, PXA-B, PXA-G1, and PXA-G2 described above.

In a present embodiment, the pixel-defining layer PDL may include an organic material. In addition, the pixel-defining layer PDL may have a predetermined color but is not limited to any one embodiment.

The common layer CL and the second electrode CE included in the light-emitting element OLED-G1 may be disposed on the first electrode AE-G1 exposed by the opening PDL-OP of the pixel-defining layer PDL.

The second electrode CE may be an integrated pattern disposed in pixels in common. The second electrode CE may be connected to each other by a partition wall WA. The common layer CL may be disconnected by the partition wall WA.

The partition wall WA may be disposed on the pixel-defining layer PDL. A region in which the pixel-defining layer PDL is disposed may be referred to as the peripheral region NPXA, and a region in which the partition wall WA is disposed on the pixel-defining layer PDL may be referred to as the partition wall region A1. The partition wall WA will be described in detail with respect to FIG. 7.

The thin-film encapsulation layer TFE may be disposed on the light-emitting element OLED-G1 and cover the light-emitting element OLED-G1. The thin-film encapsulation layer TFE may be disposed in an entire region of the display region DA. The thin-film encapsulation layer TFE may include inorganic films and an organic film disposed between the inorganic films. The inorganic films may protect pixels from moisture/oxygen. The organic film may protect the pixels from foreign substances such as dust particles.

As illustrated in FIG. 7, the partition wall WA may be disposed on the pixel-defining layer PDL. More specifically, the partition wall WA may be disposed overall on the pixel-defining layer PDL excluding the support regions A2 in the peripheral region NPXA. For example, the support regions A2 may be omitted from the peripheral region NPXA.

The partition wall WA according to an embodiment may include a first insulating pattern IN1, a second insulating pattern IN2, a first partition wall pattern W1, and a second partition wall pattern W2.

The first insulating pattern IN1 may be directly disposed on the pixel-defining layer PDL. The second insulating pattern IN2 may be disposed on the first insulating pattern IN1. In an embodiment, the first and second insulating patterns IN1 and IN2 include different materials from each other.

For example, the first insulating pattern IN1 may include at least one of indium zinc oxide, indium gallium zinc oxide, or indium tin oxide. The second insulating pattern IN2 may include at least one of silicon oxide, silicon oxynitride, or silicon nitride. The second insulating pattern IN2 may have a multilayer structure in which silicon oxide and silicon nitride are stacked.

In the present embodiment, the first insulating pattern IN1 may be a component for disconnecting a P-type hole injection layer among layers included in the common layer CL. In an embodiment, the first insulating pattern IN1 has a greater thickness than the P-type hole injection layer among the layers included in the common layer CL.

According to an embodiment, in a cross-sectional view, a width of the first insulating pattern IN1 is smaller than that of the second insulating pattern IN2. This width difference may result from the different etch rates of the first and second insulating patterns IN1 and IN2 with respect to an etchant.

Common layers CL of different pixels may be disconnected from each other by the first and second insulating patterns IN1 and IN2, with the partition wall WA therebetween. The disconnected common layers CL may be in contact with a side surface of each of the first and second insulating patterns IN1 and IN2, as well as an upper surface of the second insulating pattern IN2. According to an embodiment, the common layers CL are in contact with a side surface of the first partition wall pattern W1.

The first partition wall pattern W1 is disposed on the second insulating pattern IN2. The first partition wall pattern W1 may include metal. For example, the first partition wall pattern W1 may include aluminum. When the first partition wall pattern W1 includes aluminum, a side surface W1-S of the first partition wall pattern W1 may become oxidized and lose conductivity. Thus, an inner side W1-I of the side surface W1-S of the first partition wall pattern W1 may be defined as a nonconductor region.

The second partition wall pattern W2 may be disposed on the first partition wall pattern W1. The second partition wall pattern W2 may include a metal different from the first partition wall pattern W1. For example, the second partition wall pattern W2 may include titanium.

According to the present embodiment, a thickness of the first partition wall pattern W1 may be greater than that of the second partition wall pattern W2, while a width of the first partition wall pattern W1 may be smaller than that of the second partition wall pattern W2.

According to an embodiment, a portion of the second partition wall pattern W2 may protrude from the first partition wall pattern W1 and may be exposed from the first partition wall pattern W1. Thus, a lower surface W2-B of the second partition wall pattern W2 may be exposed from the first partition wall pattern W1. This exposure may result from a difference in etch rates of the first partition wall pattern W1 and the second partition wall pattern W2 for an etchant. A shape of the first partition wall pattern W1 and the second partition wall pattern W2 may be defined as a 'tip structure'.

According to an embodiment, a mask MS may be used in a process of forming the common layer CL. The mask MS may be a fine metal mask (FMM). According to an embodiment, during a deposition process, the partition wall WA disposed in the partition wall region A1 may be spaced apart from the mask MS by a predetermined space SSs. Thus, since the partition wall WA is not damaged during the process using the mask MS, the tip structure of the partition wall WA disposed in the partition wall region A1 may be stably maintained.

The second electrode CE may extend from the (3-1)-th light-emitting region PXA-G1 to the peripheral region NPXA and may be in contact with the partition wall WA. The second electrode CE overlapping the partition wall WA may be in contact with the side surface W1-S of the first partition wall pattern W1, the lower surface W2-B of the second partition wall pattern W2 exposed from the first partition wall pattern W1, and a side surface W2-S of the second partition wall pattern W2.

According to an embodiment, a dummy pattern CL-P may be disposed on the partition wall WA. More specifically, the dummy pattern CL-P may be disposed between an upper surface of the second partition wall pattern W2 and the second electrode CE. The dummy pattern CL-P may be a portion of the common layers CL and CL-G2 disconnected by the partition wall WA during the process of forming the common layers.

As described above, since the inner side W1-I of the first partition wall pattern W1 is oxidized and includes the nonconductor region that lacks conductivity. As a result, the second electrode CE covering the partition wall WA may be connected to another portion of the second electrode CE through the lower surface W2-B of the second partition wall pattern W2, which is exposed from the first partition wall pattern W1, and through the side surface W2-S of the second partition wall pattern W2.

According to an embodiment, a first thickness of the second electrode CE disposed on the common layer CL is greater than a second thickness of the second electrode CE covering the partition wall WA. According to an embodiment, the second electrode CE may contact only a portion of the side surface W1-S of the first partition wall pattern W1, and remain disconnected from a remaining portion of the side surface W1-S. The remaining portion of the second electrode CE may be contact the side surface W2-S of the second partition wall pattern W2 and the dummy pattern CL-P. Since the second electrode CE that is disconnected on the partition wall WA remains in contact with the partition wall WA, which includes a conductive material, the disconnected portion of the second electrode CE may be electrically connected through the partition wall WA.

FIG. 8A illustrates a cross-sectional view of one support region A2 of the peripheral region NPXA.

Referring to FIG. 8A, a spacer SP may be disposed on the pixel-defining layer PDL overlapping the support region A2. The spacer SP may be disposed in plurality in the peripheral region NPXA and may be randomly disposed in the peripheral region NPXA. For example, the spacers SP may be distributed in a non-uniform pattern such that some portions of the peripheral region NPXA include closely spaced spacers, while other portions include spacers positioned farther apart. According to an embodiment, the spacers SP may be surrounded by the partition wall WA while being spaced apart from the partition wall WA by a predetermined distance.

The spacer SP may be covered by the common layer CL and the second electrode CE. An inorganic layer included in the thin-film encapsulation layer TFE (see FIG. 6) may be disposed on the second electrode CE that covers the partition wall WA and the spacer SP.

In an embodiment, the pixel-defining layer PDL may include a colored organic material having a light-blocking property. For example, the pixel-defining layer PDL may have a black color. In this case, the spacer SP may include a transparent organic material such as polyimide.

According to an embodiment, the partition wall WA may have a first thickness TH1 (see FIG. 7) from an upper surface of the pixel-defining layer PDL, and the spacer SP may have a second thickness TH2 from the upper surface of the pixel-defining layer PDL. The second thickness TH2 of the spacer SP may be greater than the first thickness TH1 of the partition wall WA.

Accordingly, in a process using the mask MS, the partition wall WA may be spaced apart from the mask MS with the predetermined space SS therebetween, and the mask MS may be supported by the spacer SP. A process of forming the common layer CL may be performed in a state where the mask MS is supported by the spacer SP. Thus, the tip structure of the partition wall WA may be stably maintained since the mask MS and the partition wall WA are spaced apart from each other during use of the mask MS.

FIG. 8B is a cross-sectional view taken along the same region as that of FIG. 8A.

Referring to FIG. 8B, in the present embodiment, thicknesses of the pixel-defining layer PDL in the normal region A0 and the support region A2 may be different from each other. The pixel-defining layer PDL may include a first portion P1 disposed across the non-display region NPXA and a second portion P2 disposed on the support region A2. A shape of the first portion P1 and the second portion P2 may be formed through a halftone process on a single organic layer. According to an embodiment, the pixel-defining layer PDL may include a transparent organic material such as polyimide.

The partition wall WA may have the first thickness TH1 from the upper surface of the pixel-defining layer PDL, and the second portion P2 may have a third thickness TH3 from an upper surface of the first portion P1. In an embodiment, the partition wall WA may be disposed on the first portion P1. The third thickness TH3 of the second portion P2 may be greater than the first thickness TH1 of the partition wall WA.

Accordingly, during a process using the mask MS, the partition wall WA may be spaced apart from the mask MS by the predetermined space SS, and the mask MS may be supported by the second portion P2. A process of forming the common layer CL may be performed in a state where the mask MS is supported by the second portion P2. Thus, the tip structure of the partition wall WA may be stably maintained since the mask MS and the partition wall WA are spaced apart from each other when the mask MS is used.

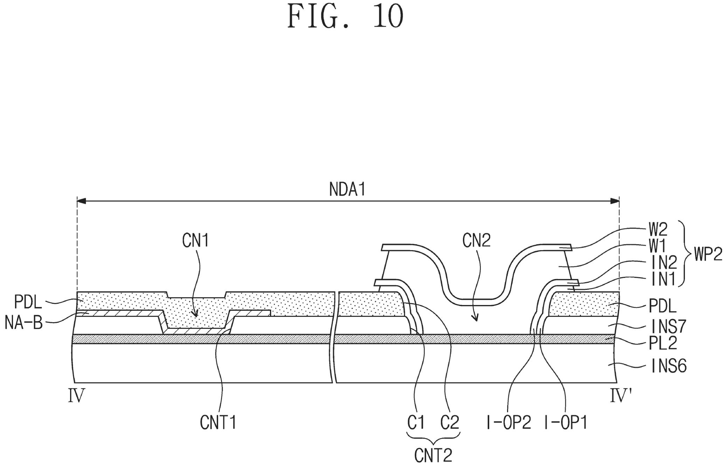

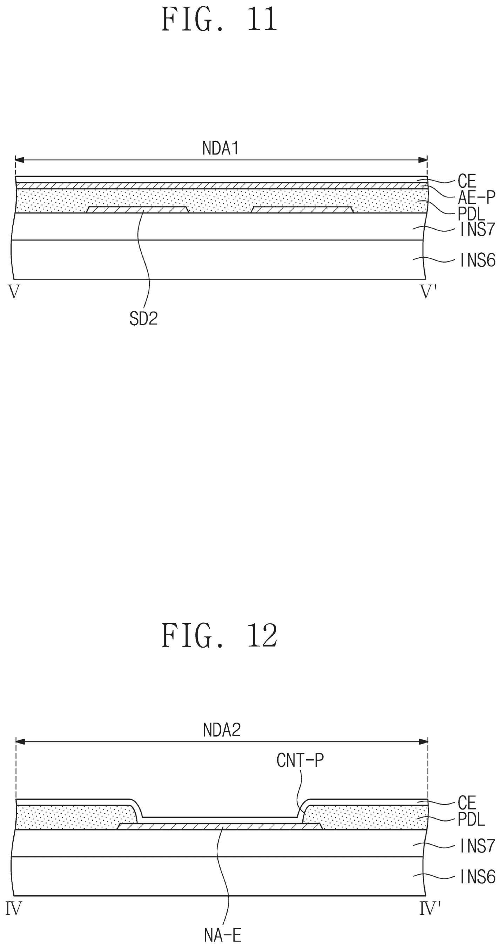

FIG. 9 is a plan view of a display panel according to an embodiment of the present inventive concept. FIG. 10 is a cross-sectional view taken along IV-IV' of FIG. 9. FIG. 11 is a cross-sectional view taken along V-V' of FIG. 9. FIG. 12 is a cross-sectional view taken along VI-VI' of FIG. 9.

Referring to FIGS. 9 to 12, a display panel DP according to an embodiment may include a display region DA including first to (3-2)-th light-emitting regions PXA-R, PXA-B, PXA-G1, and PXA-G2 and a peripheral region NPXA and a non-display region NDA adjacent to the display region DA. The display region DA and the non-display region NDA may correspond to those described above. The first to (3-2)-th light-emitting regions PXA-R, PXA-B, PXA-G1, and PXA-G2 and the peripheral region NPXA may correspond to those described above.

According to an embodiment, the non-display region NDA may include a first non-display region NDA1 adjacent to the display region DA and a second non-display region NDA2 spaced apart from the display region DA with the first non-display region NDA1 therebetween.

A partition wall WA may be disposed in a portion of the non-display region NDA and the display region DA. The partition wall WA may include a first pattern WA-D disposed in the display region DA and a second pattern WA-N connected to the first pattern WA-D and extending from the first pattern WA-D to the first non-display region NDA1.

The first pattern WA-D may be disposed on a pixel-defining layer PDL. In an embodiment, the first pattern WA-D does not overlap the first to (3-2)-th light-emitting regions PXA-R, PXA-B, PXA-G1, and PXA-G2 and may have a lattice shape.

The spacer SP described in FIG. 8A may be disposed on the pixel-defining layer PDL overlapping the display region DA. At least a portion of the spacer SP may be surrounded by the first pattern WA-D and spaced apart from the first pattern WA-D.

According to an embodiment, a region of the peripheral region NPXA, in which the first pattern WA-D is disposed, may be defined as a partition wall region A1, and a region in which spacers SP are disposed may be defined as support regions A2. A region of the peripheral region NPXA excluding the partition wall region A1 and the support regions A2 may be defined as a normal region A0.

The second pattern WA-N may be disposed in the first non-display region NDA1. The second pattern WA-N may include a normal pattern WP1 extending from the first pattern WA-D, and connection patterns WP2 extending from the normal pattern WP1 toward a signal line PL and spaced apart from each other. The connection patterns WP2 may be protrusions extending from an outer part of the lattice in the first non-display region NDA1.

The normal pattern WP1 may have a lattice shape extending from the first pattern WA-D. The normal pattern WP1 may be a portion extending from the first pattern WA-D in a direction to the first non-display region NDA1 and having the same pattern to prevent a shape of the first pattern WA-D from being disconnected. For example, as shown in FIG. 9, the normal pattern WP1 may form a lattice in which outer diagonal portions of adjacent segments of WP1 extend toward and connect with one of the connection patterns WP2. According to an embodiment, the normal pattern WP1 may be omitted, and the connection patterns WP2 may extend with the first pattern WA-D.

Signal lines PL and SD2 may be disposed in the first non-display region NDA1. The signal lines PL and SD2 in the first non-display region NDA1 may be lines disposed on the same layer as the second connection electrode CNE2 described in FIG. 6. Thus, the signal lines PL and SD2 may be disposed on the sixth insulating layer INS6 and covered by the seventh insulating layer INS7. The connection patterns WP2 may cross or intersect the signal lines PL and SD2.

According to an embodiment, an equivalent voltage may be applied to one signal line PL among the signal lines PL and SD2. In an embodiment, the equivalent voltage is a voltage used to operate the display device or drive a pixel. For example, the signal line PL may correspond to one of the first and second power lines PL1 and PL2 illustrated inFIG. 4B. Thus, the first driving voltage ELVDD or the second driving voltage ELVSS may be applied to the signal line PL.

The scan driver SDV described in FIG. 4A may be disposed in the second non-display region NDA2 of the non-display region NDA. The scan driver SDV may include transistors which are formed through the same process as the transistors T1 to T8 described in FIG. 4B. In an embodiment, a region of the second non-display region NDA2, in which the scan driver SDV is disposed, may be defined as a scan region SCA.

According to an embodiment, a protective electrode NAE may be disposed on the scan region SCA. Since the protective electrode NAE is disposed to overlap the scan driver SDV and an equivalent voltage is applied thereto, the protective electrode NAE may protect the scan driver SDV from electrical stimuli introduced to the non-display region NDA. Accordingly, the electronic device ED with enhanced display quality may be provided. The protective electrode NAE may receive an equivalent voltage since the protective electrode NAE is connected to the signal line PL. More description thereof will be provided later.

The protective electrode NAE may include first electrodes NA-E arranged along the first direction DR1 and each extending along the second direction DR2, second electrodes NA-C disposed between two first electrodes NA-E adjacent to each other along the first direction DR1 and arranged along the second direction DR2, and third electrodes NA-B protruding towards the signal line PL, from the first electrode NA-E which is the most adjacent to the signal line PL2 and arranged along the second direction DR2. The first to third electrodes NA-E, NA-C, and NA-B are a connected integrated pattern but will be described separately for convenience of description. The protective electrode NAE may include one or more holes (e.g., electrode holes). The electrode holes may be rectangular in shape in some embodiments but are not limited to thereto.

According to an embodiment, the protective electrode NAE may be disposed on the same layer as the first electrode AE described in FIG. 6. Thus, the protective electrode NAE may be patterned through the same process and include the same material as the first electrode AE.

According to an embodiment, the protective electrode NAE may be disposed on the same layer as a second electrode CE. Thus, the protective electrode NAE may be patterned through the same process and include the same material as the second electrode CE.

Two first electrodes NA-E adjacent to each other along the first direction DR1 and two second electrodes NA-C disposed between the two first electrodes NA-E and arranged along the second direction DR2 may define one electrode hole H1 or H2.

According to the present embodiment, first electrode holes H1 arranged along the second direction DR2 may be defined as a first hole group, and second electrode holes H2 arranged along the second direction DR2 may be defined as a second hole group. The first hole group and the second hole group may be spaced apart from each other along the first direction DR1 with one first electrode NA-E therebetween. The first electrode holes H1 included in the first hole group and the second electrode holes H2 included in the second hole group may be shifted along the second direction DR2. For example, the first electrode holes H1 may be laterally offset from the second electrode holes H2 by a predetermined distance along the second direction DR2 to facilitate alignment or increase structural uniformity.

According to an embodiment, a portion of each of the third electrodes NA-B and a portion of each of the connection patterns WP2 may overlap the signal line PL. According to an embodiment, the third electrodes NA-B and the connection patterns WP2 may be alternately arranged along the second direction DR2 on the signal line PL.

An embodiment in which one third electrode NA-B and one connection pattern WP2 are alternately arranged along the second direction DR2 is illustrated in FIG. 9, but is not limited thereto. The third electrodes NA-B and the connection patterns WP2 may instead be regularly disposed to overlap the signal line PL.

The third electrodes NA-B may be connected to the signal line PL through a first contact hole CN1, and the connection patterns WP2 may be connected to the signal line PL through a second contact hole CN2.

Referring to FIG. 10, the first contact hole CN1 may be defined as a first contact portion CNT1 overlapping the first non-display region NDA1 and penetrating the seventh insulating layer INS7. A portion of the signal line PL may be exposed through the first contact hole CN1, and the third electrode NA-B may be in contact with the portion of the signal line PL, exposed by the first contact hole CN1.

Referring to FIG. 11, an electrode pattern AE-P and the second electrode CE may be in contact with each other in the first non-display region NDA1. The electrode pattern AE-P may be a pattern connected to the first electrodes AE (see FIG. 6) disposed in the display region DA and the protective electrode NAE disposed in the second non-display region NDA2.

Referring to FIG. 12, the first electrode NA-E and the second electrode CE may be connected, in the second non-display region NDA2, through a contact portion CNT-P, in which the pixel-defining layer PDL overlapping the second non-display region NDA2, is penetrated. Thus, the second electrode CE and the first electrode AE-G1 described in FIG. 6 may be connected to each other in the non-display region NDA.

According to an embodiment, the protective electrode NAE may receive an equivalent voltage, for example, the second driving voltage ELVSS since the protective electrode NAE is connected to the signal line PL through the first contact hole CN1. Since the protective electrode NAE to which an equivalent voltage is applied is disposed on the scan region SCA, the scan driver SDV may be protected from external electricity. Accordingly, the electronic device ED with enhanced display quality may be provided.

The second contact hole CN2 may be defined as a second contact portion CNT2 that overlaps the first non-display region NDA1. The second contact portion CNT2 may include a first side portion C1 penetrating the seventh insulating layer INS7 and a second side portion C2 penetrating the pixel-defining layer PDL. A portion of the signal line PL may be exposed through the second contact hole CN2.

First and second insulating patterns IN1 and IN2 of the connection pattern WP2 disposed in the second contact hole CN2 may include insulating openings I-OP1 and I-OP2 overlapping the second contact hole CN2. A first partition wall pattern W1 of the connection pattern WP2 disposed in the second contact hole CN2 may be in contact with the portion of the signal line PL, exposed by the second contact hole CN2.

According to an embodiment, the partition wall WA may receive an equivalent voltage, for example, the second driving voltage ELVSS since the partition wall WA is connected to the signal line PL through the second contact hole CN2. As described in FIG. 6, since the second electrode CE is disposed over the display region DA and is in contact with the partition wall WA, the second electrode CE may provide the second driving voltage ELVSS to the pixels PX (see FIG. 4A). Accordingly, the electronic device ED with enhanced display quality may be provided.

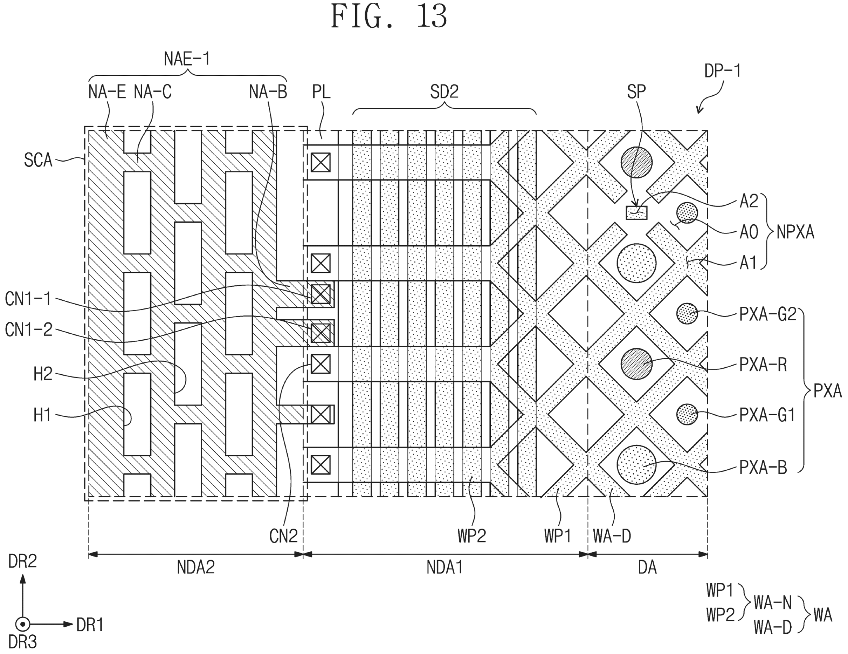

FIG. 13 is a plan view of a display panel according to an embodiment of the present inventive concept. Components that are the same as or similar to the components described in FIGS. 9 to 12 are denoted as the same or similar reference numerals or symbols, and duplicate descriptions thereof are omitted.

Referring to FIG. 13, a display panel DP-1 according to an embodiment may include a display region DA including first to (3-2)-th light-emitting regions PXA-R, PXA-B, PXA-G1, and PXA-G2 and a peripheral region NPXA and a non-display region NDA adjacent to the display region DA.

According to an embodiment, the first to (3-2)-th light-emitting regions PXA-R, PXA-B, PXA-G1, and PXA-G2 may each have a circular shape. Areas of the first to (3-2)-th light-emitting regions PXA-R, PXA-B, PXA-G1, and PXA-G2 may be different from each other. However, a shape of each of the first to (3-2)-th light-emitting regions PXA-R, PXA-B, PXA-G1, and PXA-G2 may correspond to that described in FIG. 9 and is not limited to any one embodiment.

A partition wall WA may be disposed in a portion of the non-display region NDA and the display region DA. The partition wall WA may include a first pattern WA-D disposed in the display region DA and a second pattern WA-N connected to the first pattern WA-D and extending from the first pattern WA-D to a first non-display region NDA1.

The first pattern WA-D and a normal pattern WP1 of the second pattern WA-N may have a lattice shape. Connection patterns WP2 of the second pattern WA-N may each extend from the normal pattern WP1 in the first direction DR1 towards a signal line PL and may be spaced apart from each other along the second direction DR2.

Signal lines PL and SD2 may be disposed in the first non-display region NDA1. An equivalent voltage may be applied to one signal line PL among the signal lines PL and SD2. For example, the signal line PL may correspond to one of the first and second power lines PL1 and PL2 described in FIG. 4B. Thus, the first driving voltage ELVDD or the second driving voltage ELVSS may be applied to the signal line PL.

A protective electrode NAE-1 may be disposed on a scan region SCA of a second non-display region NDA2. The protective electrode NAE-1 may include first electrodes NA-E arranged along the first direction DR1 and each extending along the second direction DR2, second electrodes NA-C disposed between two first electrodes NA-E adjacent to each other along the first direction DR1 and arranged along the second direction DR2, and third electrodes NA-B protruding, in a direction to the signal line PL, from the first electrode NA-E which is the most adjacent to the signal line PL2 and arranged along the second direction DR2.

According to an embodiment, on the signal line PL, the third electrodes NA-B and the connection patterns WP2 may be alternately arranged, and may be arranged irregularly.

For example, the third electrodes NA-B may not be disposed between two connection patterns WP2 adjacent to each other along the second direction DR2, and two third electrodes NA-B may be disposed between two connection patterns WP2 adjacent to each other along the second direction DR2. For example, along the second direction DR2, a third electrode NA-B may be absent between two adjacent connection patterns WP2, or two third electrodes NA-B may be disposed between two adjacent connection patterns WP2. One third electrode NA-B may be connected to the signal line PL through a (1-1)-th contact hole CN1-1, and the other third electrode NA-B may be connected to the signal line PL through a (1-2)-th contact hole CN1-2.

According to an embodiment, a shape of electrode holes H2 disposed in the second non-display region NDA2 adjacent to the first non-display region NDA1 may be different from a shape of adjacent electrode holes H1 and H2.

Although the description refers to various embodiments, those skilled in the art will understand that the present disclosure may be modified and changed in various ways without departing from the scope of the present invention as defined by the claims.

## Claims

1. An electronic device comprising:
a display panel comprising a display region and a non-display region adjacent to the display region, the non-display region comprising a scan region; and
a scan driver disposed in the non-display region of the display panel, receives a scan control signal from a timing controller, and overlaps the scan region,
wherein the display panel comprises:
a substrate which includes light-emitting regions disposed in the display region and a peripheral region disposed between the light-emitting regions;
a plurality of pixels overlapping the display region;
a pixel-defining layer which overlaps the peripheral region and includes openings corresponding to the light-emitting regions;
a partition wall disposed on the pixel-defining layer, the partition wall comprising a first pattern overlapping the display region and a second pattern extending from the first pattern to overlap the non-display region;
a signal line disposed between the display region and the scan region,
wherein the signal line is configured to receive a driving voltage for driving the pixels; and
a protective electrode overlapping the scan region and the scan driver,
wherein the protective electrode and the second pattern are connected to the signal line through contact holes.

2. The electronic device of claim 1, wherein the protective electrode is disposed on the same layer as electrodes of light emitting elements of the pixels, and the signal line is disposed lower than the electrodes.

3. The electronic device of claim 1 or 2, wherein:
the first pattern is disposed on the pixel-defining layer and has a lattice shape spaced apart from the openings; and
the second pattern comprises a normal pattern extending from the first pattern and having a shape similar to a shape of the first pattern and connection patterns extending from the normal pattern in a direction towards the signal line and spaced apart from each other.

4. The electronic device of claim 3, wherein the protective electrode comprises:
first electrodes arranged along a first direction and extending along a second direction crossing the first direction;
second electrodes arranged along the second direction and disposed between the first electrodes adjacent to each other along the first direction; and
third electrodes arranged along the second direction and protruding, in a direction towards the signal line, from one of the first electrodes adjacent to the signal line.

5. The electronic device of claim 4, wherein the first electrodes adjacent to each other along the first direction and second electrodes disposed between the first electrodes of the protective electrode define an electrode hole.

6. The electronic device of claim 5, wherein:
the electrode hole is provided as a plurality of electrode holes arranged along the second direction to define hole groups; and
electrode holes included in the hole groups adjacent to each other along the first direction are shifted along the second direction.

7. The electronic device of claim 4, 5 or 6, wherein the connection patterns and the third electrodes are alternately arranged on the signal line along the second direction, and/or are arranged regularly.

8. The electronic device of any one of claims 4 to 7, further comprising an interlayer insulating layer disposed between the third electrodes and the signal line and including an organic material,
wherein contact holes are present penetrating the interlayer insulating layer, and the third electrodes are connected to the signal line through the contact holes.

9. The electronic device of any one of the preceding claims, wherein the partition wall comprises:
a first insulating pattern disposed on the pixel-defining layer;
a second insulating pattern disposed on the first insulating pattern;
a first partition wall pattern disposed on the second insulating pattern; and
a second partition wall pattern disposed on the first partition wall pattern, optionally wherein:
the first insulating pattern comprises at least one of indium zinc oxide, indium gallium zinc oxide, or indium tin oxide; and
the second insulating pattern comprises at least one of silicon oxide, silicon oxynitride, or silicon nitride, and
optionally wherein:
the first partition wall pattern comprises aluminum; and
the second partition wall pattern comprises titanium.

10. The electronic device of claim 9, wherein:
a thickness of the first partition wall pattern is greater than a thickness of the second partition wall pattern;
a width of the second partition wall pattern is greater than a width of the first partition wall pattern; and
a portion of a lower surface of the second partition wall pattern protrudes from the first partition wall pattern and is exposed from the first partition wall pattern.

11. The electronic device of claim 10, further comprising:
a dummy pattern disposed on an upper surface of the second partition wall pattern,
wherein the dummy pattern includes the same material as a common layer disposed between electrodes of light emitting elements of the pixels.

12. The electronic device of claim 11, wherein an electrode extends from one of the light-emitting regions to the peripheral region and covers a side surface of the first partition wall pattern, the portion of the lower surface of the second partition wall pattern, and the dummy pattern.

13. The electronic device of claim 9, further comprising an interlayer insulating layer disposed between the second pattern and the signal line and including an organic material,
wherein contact holes are present penetrating the interlayer insulating layer and the pixel-defining layer,
first and second insulating patterns of the second pattern, which are disposed in the contact holes, include an insulating opening overlapping the contact holes, and
the first partition wall pattern of the second pattern, which is disposed in the contact holes, is connected to the signal line through the insulating opening and the contact holes.

14. The electronic device of any one of the preceding claims, wherein the pixels comprise:
a first pixel providing red light;
a second pixel spaced apart from the first pixel along a first direction and providing blue light; and
third and fourth pixels disposed between the first pixel and the second pixel, spaced apart from each other along a second direction crossing the first direction, and providing green light.

15. The electronic device of claim 14, wherein the light-emitting regions comprise:
a first light-emitting region overlapping the first pixel;
a second light-emitting region overlapping the second pixel; and
third and fourth light-emitting regions overlapping the third and fourth pixels,
wherein an area of the first light-emitting region is smaller than an area of the second light-emitting region and larger than an area of each of the third and fourth light-emitting regions.
